# EUROPEAN PATENT SPECIFICATION

(11) **EP 2 082 441 B1**
(45) Date of publication and mention of the grant of the patent: **18.12.2013**
(21) Application number: 07819030.3
(22) Date of filing: 16.10.2007
(51) Int. Cl.: H01L 33/00, H01L 33/50, H01L 33/56, H01L 33/60

(54) **LIGHT EMITTING DIODE MODULE AND METHOD FOR MANUFACTURING THE SAME**
LEUCHTDIODENMODUL UND DESSEN HERSTELLUNGSVERFAHREN
MODULE A DIODE ELECTROLUMINESCENTE ET SA METHODE DE FABRICATION

(30) Priority: 20.10.2006 EP 06022064
(43) Date of publication of application: 29.07.2009
(60) Divisional application: 10184330.8
(73) Proprietor: Tridonic Jennersdorf GmbH, 8380 Jennersdorf (AT); Lumitech Produktion und Entwicklung GmbH, 8380 Jennersdorf (AT)
(72) Inventor: SCHRANK, Franz, 8047 Raab (AT); HOSCHOPF, Hans, 8380 Jennersdorf (AT)
(74) Representative: Rupp, Christian
(86) International application number: PCT/EP2007/008960
(87) International publication number: WO 2008/046583

(56) References cited:
- EP-A- 0 854 523
- EP-A- 1 059 678
- EP-A- 1 641 050
- WO-A-2005/117071
- WO-A-2007/018560
- DE-C1- 10 245 946
- JP-A- 2006 066 786
- US-A- 5 851 847
- US-A1- 2003 173 655

## Description

The present invention relates to the field of light-emitting diode (LED) modules. The module is designed to allow the directed passage of light from the light-emitting diode chip.

The invention also relates to a method for manufacturing such LED modules.

From the state of the art it is known to cover so called COB (chip-on-board) LED modules with a so called globe-top which is based on a heat-curable resin. Such a globe-top is usually applied with standard dispensing equipment. However, the performance of LED modules having such a globe-top is not satisfying all requirements of different application fields. One of the main disadvantages actually is the directive characteristics, i.e. the wide emission angle, which is not well suited for using such a LED module with secondary optics, such as for example lenses or light guides.

In order to have a smaller emission angle of the light emitted by COB LED modules the die is sometimes placed in a cavity with a reflecting wall. However, due to the spherical shape of the top surface of the globe-top, the contribution of the reflecting wall on the emission angle is not satisfying.

The second disadvantage of the globe-top cover is the low mechanical stability of the LED modules which is a disadvantage for the handling and mounting of the LED modules. In this context is to be noted that based on the requirements on a high UV stability, usually silicones are used as resins for the globe-top. Unfortunately, these rubber-like materials apply a high mechanical stress to bond wires if the spherical shape of the globe-top is warped.

WO 2006/017484A1 proposes a dam-and-fill technology in order to protect parts of a printed circuit board against electric short circuits.

EP 0854523 A2 discloses a light emitting diode module comprising a light emitting diode chip mounted in a cavity of a stem made from an epoxy resin comprising reflecting particles, and a central filling made from a silicone resin which is filled into the cavity of the stem, wherein the stem and the central filling are chemically linked across the interface between the two materials.

EP 1059678 A2 discloses a light emitting diode module comprising a light emitting diode chip mounted on a board, a dam, and a central filling which is filled into the dam, wherein the dam and the central filling are made from a cured silicone resin.

US 5851847 discloses a method of manufacturing a light emitting diode module comprising the steps of mounting a light emitting diode chip on a board, dispensing an uncured liquid silicone resin dam onto the board, filling the dam with an uncured liquid silicone resin central filling, and simultaneously curing the resin of the dam and the central filling thereby making a chemical linking across the interface between the two materials.

JP 2006066786 discloses a light emitting diode module comprising a light emitting diode chip mounted on a board, a translucent dam made from a cured silicone resin, and a central filling made from a cured silicone resin comprising colour conversion particles.

Therefore, it is the object of the present invention to propose an improved LED module and method of manufacturing.

This object is achieved by means of the features of independent claims 1 and 11. Dependent claims 2-10 and 12-14 develop further the central idea of the present invention.

According to a first aspect of the invention a LED module is proposed. The module allows for a passage and preferably a directed passage of light from the LED chip. The module comprises an outer non-transparent and reflective dam and a central filling, which central filling has been filled into the outer dam after the manufacturing of the outer dam. The outer dam and the central filling are respectively made from a cured silicone resin. The central filling is chemically linked to the outer dam across the interface.

Note that "outer dam" does not represent any limitation as to the shape, as long as the dam can act as a dam surrounding the central filling and being stable in shape even in the uncured state.

The resin is silicone.

The dam comprises reflecting particles such as for example white pigments. The reflecting particles are preferably present throughout the bulk of the outer dam material. The dam thus has the role of a reflector applied in the liquid state on a board.

The outer dam can comprise 10 to 60 weight % of the reflecting particles.

The resin of the outer dam and the central filling have the same chemical structure, e.g. they can be chemically identical.

The resin of the outer dam can be selected to have a storage modulus of more than 1000 Pa before being cured.

The resin of the outer dam can be selected such that it has for example a viscosity of more than 100 Pa*s when measured at a shear rate of 1 1/s, again before being cured.

The material of the outer dam can comprise particulate material such as e.g. silica, which particulate material or fine grained material can be used in order to set the desired rheological properties of the uncured dam resin.

The height of the outer dam can be equal to or more than 1mm.

The mean thickness of the outer dam can be selected according to the requirements of the final module. For a diameter of approx. 5 mm the thickness can be equal to or less than 0.5mm. For larger diameters the thickness is adjusted to more than 0.5 mm, for smaller diameters the thickness might be less than 0.5 mm.

The inner diameter of the dam can be as small as e.g. 0.1 to 1mm.

The LED module comprises a LED chip mounted on a board as well as a cover. The cover comprises the outer dam and a central filling, which has been filled into the outer dam and at least partially on top of the LED chip after the outer dam has been made on the board surrounding the LED chip.

The central filling is made from a silicone resin, such as e.g a transparent silicone.

The central filling comprises color conversion particles which convert light emitted from the LED chip into light of a second, lower frequency spectrum.

The inner wall of the outer dam can be distanced from the LED chip, such that the distance between the outer dam and the LED chip is filled with the central filling which thus is also in contact with the board on which the LED chip is mounted e.g. in a chip-on-board technology.

The central filling can fill the entire volume defined by the outer dam such that the top surface of the filling is on the same level as the maximum height of the outer dam.

Preferably the outer dam is raised higher from the board than the LED-chip.

The invention also relates to a method for manufacturing a LED module. An outer dam made from an uncured liquid silicone resin is first dispensed on a board. This outer dam is then filled with an uncured liquid silicone resin. Finally, in one single step, the resin of the outer dam and the resin of the central filling are cured and a chemically linked interface between the outer dam and the central filling is provided which guarantees a stronger adhesion between the central filling and the outer dam.

Further aspects, advantages and objects of the present invention will become evident from the following detailed explanation of embodiments of the present invention when taking in conjunction with the figures of the enclosed drawings.
Fig. 1 shows schematically a side view of a LED module having a cover according to the present invention.
Fig. 2 shows a top view of a LED module with a cover according to the present invention.
Fig. 3 shows a perspective view of a cover of the present invention.
Fig. 4 shows a light-erasable storage device not part of the present invention, and
Fig. 5 shows the use of the present invention in connection with a light guiding element.

To start with, a method for manufacturing a LED module according to the present invention will be explained.

As the cover element of the LED module has a role a optical element, its precision has to go far beyond the precision necessary for purely protective purposes as known from WO 2006/017484A1.

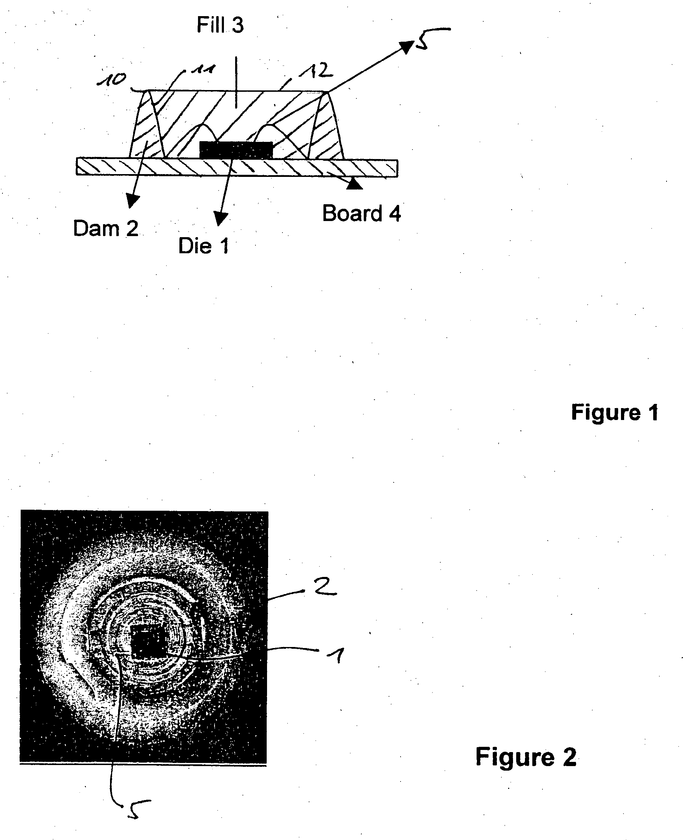

The following method will be explained in the context of producing a LED module as shown in Fig. 1.

In a first step, a ring-shaped dam (torus) of an uncured liquid silicone resin is dispensed around the LED chip (LED diode) 1, which is placed on a board 4.

Preferably a plane board without recessions is used, as the reflective effect of walls of a recession can be achieved by the dam walls.

Dispensing techniques for resins and silicones are known as such from the prior art. Due to the dispensing technique the cross-sectional view of the dam tapers to the peak 10 of the dam 2. Thus the inner face 11 of dam 2 is inclined and preferably is steeper at its upper part which can be of advantage for reflection purposes.

The cross-sectional shape of the dam 2 can be controlled by the diameter of the dispensing needle used, the flow characteristics of the liquid dam material and the flow (dispensing) speed.

In the example shown in Fig. 1 the LED chip 1 is mounted according to the chip-on-board (COB) technology. The bond wires are designated with the reference numeral 5.

The wall of uncured liquid silicone resin is dispensed on the board 4 around the LED die 1 thus forming a ring/dam.

The dam material is non-transparent for the wavelength of the light passing through the filling inside the dam.

Please note that 'ring' in the context of the present description and claims does not constitute any limitation as to the contour of the walls, i.e. the dam does not necessarily have a spherical shape, but can e.g. have the shape of a square, an oval, a rectangular shape etc..

The circular shape is preferred if only a single LED chip is placed inside the dam (see later on), while a rectangular or oval shape is preferred in case a plurality of LED chips are placed inside the dam in a row configuration.

Different silicone resins can be used for the dam 2. Silicones exhibit high UV stability.

The rheological characteristics of the uncured liquid silicone resin material for building the wall of the dam 2 have to be well selected such that after the dispensing the uncured liquid resin is stable in shape until it is cured.

To this regard the storage modulus should be rather high and e.g. be at least 1000 Pa. The loss factor should be approximately 0.5.

The viscosity of the uncured liquid silicone resin should preferably be higher than 200 Pa*s (when measured at a shear rate of 1 1/s). A liquid silicone resin material of such characteristics is suited for achieving a wall e.g. with a height of more than 1mm and a mean thickness of less than 0.5mm.

In order to adjust the rheological characteristics of the uncured liquid silicone resin material, silica or other particulate material (fine grained material) can be added to the liquid silicone resin.

As can be seen from Fig. 1, preferably the wall 2 is distanced from the LED die 1.

Furthermore, the height of the dam 2 is set to be higher than the height of the LED die 1. E.g. the height of the ring 2 can be twice or three times the height of the LED die 1.

A higher light reflectivity of the wall of the dam 2 is achieved by adding reflecting substances such as e.g. white pigments into the liquid silicone resin material. Examples for such pigments are pigments made from TiO₂, BaTiO₃, BaSO₄ and/or ZrO₂.

Preferably, these pigments are added to the uncured liquid silicone resin in an amount of 10% to 60% per weight.

Thus the entire material of the dam will have a non-transparent and preferably white reflecting appearance. The reflection from light from the LED die 1 occurs at the inner face 11 of the ring/dam 2 reflecting light back to the interior of the dam 2 and away from the LED die 1.

In a second step of the manufacturing process the volume confined by the inner walls of the self-stable dam 2 is filled with an uncured liquid silicone resin material. As can be seen from Fig. 1, this filling is preferably made such that the top level of the filling flushes with the top level of the walls of the dam 2. Due to the filling with the uncured liquid silicone resin the top surface 12 of the central filling 3 will be preferably flat.

To summarize, liquid uncured silicone resin is filled in a cavity defined by a self-stable dam of uncured liquid silicone resin, which preferably chemically identical, but can be different regarding optical and mechanical characteristics (as the material of the outer dam 2 can be provided with different "additives" as the material of the central filling 3).

The chemical identity has to be such that the silicone material used for the dam and the filling, respectively, can be cured using the same curing mechanism in order to produce a chemical linking across the interface between the two materials.

The filling material entirely covers the top surface of the LED die 1. It also covers the space between the LED die 1 and the walls of the dam 2 (if any) and contacts the board 4 in this gap between the LED die 1 and the dam 2.

The material for the central filling 3 is also an uncured liquid silicone resin.

The resin for the central filling 3 is made from the same silicone material as the resin for the dam 2 such that these resins are chemically identical.

Colour conversion particles are added to the fill material of the central filling 3. The type and the amount of the colour conversion particles depends on the desired colour temperature of the LED module, which is known as such from the prior art. Preferably there is an increasing concentration gradient of the color conversion particles from the top to the bottom of the filling, which can be achieved e.g. by allowing the color conversion particles to sink towards the bottom of the filling.

In a third step the liquid silicone resins i.e. the resins of the central filling 3 and the dam 2 are cured. By a single curing cycle both of the silicone materials can be cured and chemically linked together at their interface.

The above-outlined manufacturing process relies on' a relatively high mechanical stability of the material of the wall in the uncured "liquid" state. Again, in order to achieve this mechanical stability in the liquid state, additional filling materials such as for example silica can be added to the resin for the dam 2.

Both for the manufacturing of the dam 2 as well as for the filling a standard computer controlled dispensing equipment can be used.

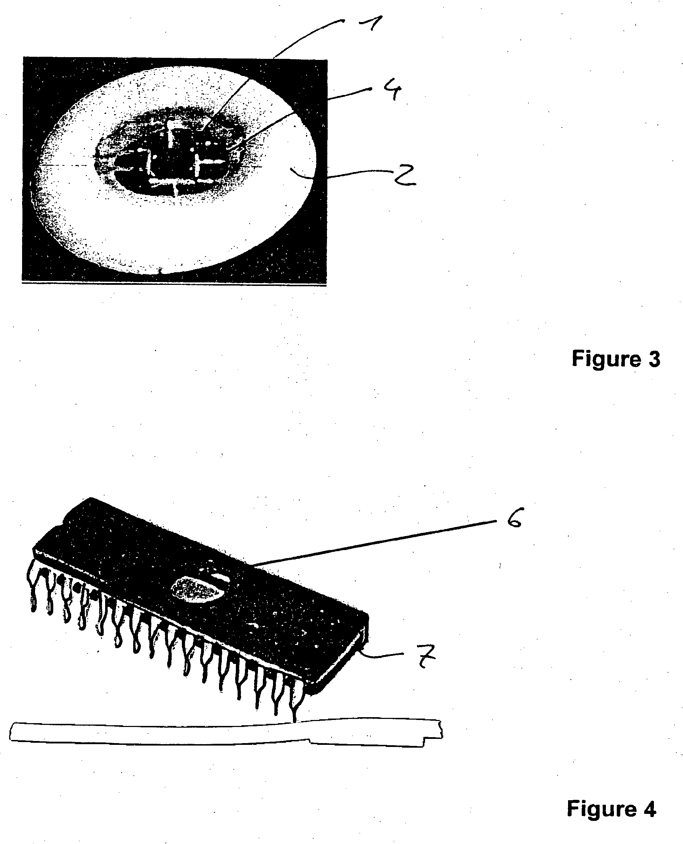

Figures 2 and 3 show a top view (Fig. 2) and a perspective view (Fig. 3) of a LED module according to the present invention and being mounted in chip-on-board technology. In these examples the material of the dam 2 is highly reflective as white pigments have been added throughout the base resin for the dam 2.

On the other hand, the resin for the filling 3 is essentially transparent and the bond wires 5 can be seen which are surrounded and stabilized by the material of the central filling 3.

In Fig. 4 a light-erasable memory device not forming part of the present invention such as for example an EEPROM 7 is shown.

The cover can protect the opening 6 of the casing of the light erasable memory device 7, which opening is designed for the light erasing process.

Due to the "dam-and-fill" coverage, which can be made of highly transparent materials depending on the requirements of the erasing/programming light beam, a protection against environmental influences as well as perfect fit to the erasing/programming light source can be achieved. Especially, the protection against scattered light and stray light is a big advantage of the dam and fill cover. The outer ring thus can not only serve as a reflective element, but additionally or alternatively as an opaque shielding.

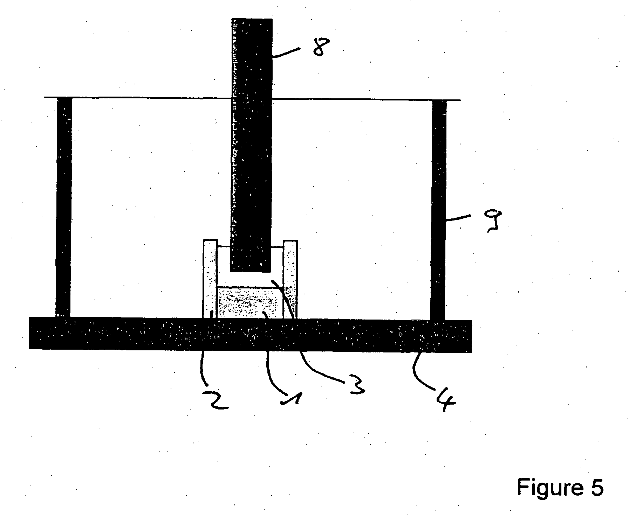

Finally, Fig. 5 shows the use of a LED module according to the present invention in connection with light guides and optical fibers.

The dam material (ring) 2 provides a mechanical stability, such that it is possible to provide the filling 3 on top of the LED chip as a very fluid and highly transparent synthetic resin.

I the example shown in Fig. 5 there is no gap between the dam 2 and the LED chip 1 such that the filling material is only present on top of the LED chip 1.

Furthermore, the filling 3 is not completely flush with the top of the wall of the dam 2.

The reference sign 8 designates an optical fiber to which light from the LED chip 1 is to be transmitted (transversing the fill material 3).

The reference sign 9 designates mechanical fixture for optical fibers.

The arrangement as shown in Fig. 5 provides for an improved light feeding from the LED chip to the optical fibre.

## Claims

1. A light-emitting diode module comprising a light-emitting diode chip (1) mounted on a board, and a cover, the cover comprising an outer dam (2) dispensed on the board, and a central filling (3), which is filled into the outer dam (2), the outer dam (2) and the central filling (3) being respectively made from a cured silicone resin,
wherein the central filling (3) is chemically linked to the outer dam (2) across the interface between the two materials,
**characterized in that** the outer dam (2) is non-transparent and comprises reflecting particles, and the central filling (3) comprises colour conversion particles.

2. The light-emitting diode module according to claim 1, wherein the cross-section of the outer dam (2) tapers to the peak (10) of the dam (2) such that the inner face (11) of the dam (2) is inclined.

3. The light-emitting diode module according to claim 1 or 2, wherein the top surface of the filling (3) is at the same level as the maximum height of the outer dam (2) or is not completely flush with the top level thereof.

4. The light-emitting diode module according to any of the preceding claims, wherein the reflecting particles are white pigments.

5. The light-emitting diode module according to any of the preceding claims, wherein the outer dam (2) comprises 10 to 60 weight % of reflecting particles.

6. The light-emitting diode module according to any of the preceding claims, wherein the light-emitting diode chip (1) is mounted on the board according to a chip-on-board technology.

7. The light-emitting diode module according to any of the preceding claims, wherein the inner wall of the outer dam (2) is distanced from the light-emitting diode chip (1), the distance between the outer dam (2) and the light-emitting diode chip (1) being filled with the central filling (3).

8. The light-emitting diode module according to any of the preceding claims, wherein the central filling (3) fills the entire volume defined by the outer dam (2).

9. The light-emitting diode module according to any of the preceding claims, wherein the outer dam (2) is higher than the light-emitting diode chip (1).

10. The light-emitting diode module according to any of the preceding claims, wherein the height of the outer dam (2) has at least the height of the element to be covered.

11. A method for manufacturing a light-emitting diode module, the method comprising the following steps:
- mounting a light-emitting diode chip (1) on a board,
- dispensing on the board an outer dam (2) made from an uncured liquid silicone resin, the outer dam (2) surrounding the light-emitting diode chip (1),
- making a central filling (3) of the volume defined by the outer dam (2), the central filling (3) being made from an uncured liquid silicone resin covering the top surface of the light-emitting diode chip (1),
- curing in one single step the resin of the outer dam (2) and the central filling (3) and making a chemical linking across the interface between the outer dam (2) and the central filling (3),
**characterized in that**
the outer dam (2) is non-transparent and comprises reflecting particles, and the central filling (3) comprises colour conversion particles.

12. The method according to claim 11, wherein the board is a plane board.

13. The method according to any of claims 11 to 12,
wherein the resin of the outer dam (2) has a storage modulus of more than 100 Pa before being cured.

14. The method according to any of claims 11 to 13,
wherein the resin of the outer dam (2) has a viscosity of more than 100 Pa*s when measured at a shear rate of 1 1/s before being cured.

## Patentansprüche

1. Lichtemittierendes Diodenmodul mit einem auf einer Platine angebrachten, lichtemittierenden Diodenchip (1) und einer Abdeckung, wobei die Abdeckung einen auf die Platine aufgetragenen, äußeren Damm (2) und eine mittige Füllung (3) aufweist, die in den äußeren Damm (2) gefüllt ist, wobei der äußere Damm (2) und die mittige Füllung (3) jeweils aus einem gehärteten Silikonharz bestehen,
wobei die mittige Füllung (3) mit dem äußeren Damm (2) über die Grenzfläche zwischen den beiden Materialien chemisch verbunden ist,
**dadurch gekennzeichnet, dass** der äußere Damm (2) nichttransparent ist und reflektierende Partikel aufweist und dass die mittige Füllung (3) Farbumwandlungspartikel aufweist.

2. Lichtemittierendes Diodenmodul gemäß Anspruch 1, wobei sich der Querschnitt des äußeren Damms (2) zu der Spitze (10) des Damms (2) hin derart verjüngt, dass die Innenfläche (11) des Damms (2) geneigt ist.

3. Lichtemittierendes Diodenmodul gemäß Anspruch 1 oder 2, wobei sich die Oberfläche der Füllung (3) auf gleicher Ebene wie die maximale Höhe des äußeren Damms (2) befindet oder nicht ganz bündig mit dessen Oberfläche ist.

4. Lichtemittierendes Diodenmodul gemäß einem der vorhergehenden Ansprüche, wobei die reflektierenden Partikel aus weißen Pigmenten bestehen.

5. Lichtemittierendes Diodenmodul gemäß einem der vorhergehenden Ansprüche, wobei der äußere Damm (2) 10 bis 60 Gew-% reflektierender Partikel aufweist.

6. Lichtemittierendes Diodenmodul gemäß einem der vorhergehenden Ansprüche, wobei der lichtemittierende Diodenchip (1) gemäß einer Chip-on-Board Technik auf der Platine angebracht ist.

7. Lichtemittierendes Diodenmodul gemäß einem der vorhergehenden Ansprüche, wobei die Innenwand des äußeren Damms (2) von dem lichtemittierenden Diodenchip (1) beabstandet ist, wobei der Abstand zwischen dem äußeren Damm (2) und dem lichtemittierenden Diodenchip (1) mit der mittigen Füllung (3) gefüllt ist.

8. Lichtemittierendes Diodenmodul gemäß einem der vorhergehenden Ansprüche, wobei die mittige Füllung (3) das gesamte, durch den äußeren Damm (2) festgelegte Volumen füllt.

9. Lichtemittierendes Diodenmodul gemäß einem der vorhergehenden Ansprüche, wobei der äußere Damm (2) höher als der lichtemittierende Diodenchip (1) ist.

10. Lichtemittierendes Diodenmodul gemäß einem der vorhergehenden Ansprüche, wobei die Höhe des äußeren Damms (2) zumindest die Höhe des zu bedeckenden Elements aufweist.

11. Verfahren zur Herstellung eines lichtemittierenden Diodenmoduls, mit den folgenden Schritten:
- Anbringen eines lichtemittierenden Diodenchips (1) auf einer Platine,
- Aufbringen eines aus einem ungehärteten flüssigen Silikonharz bestehenden, äußeren Damms (2) auf der Platine, wobei der äußere Damm (2) den lichtemittierenden Diodenchip (1) umgibt,
- Herstellen einer mittigen Füllung (3) des durch den äußeren Damm (2) festgelegten Volumens, wobei die mittige Füllung (3) aus einem ungehärteten flüssigen Silikonharz besteht, das die obere Fläche des lichtemittierenden Diodenchips (1) bedeckt,
- Härten des Harzes des äußeren Damms (2) und der mittigen Füllung (3) in einem einzigen Schritt sowie Herstellen einer chemischen Verbindung über die Grenzfläche zwischen dem äußeren Damm (2) und der mittigen Füllung (3),
**dadurch gekennzeichnet, dass**
der äußere Damm (2) nichttransparent ist und reflektierende Partikel enthält und dass die mittige Füllung (3) Farbumwandlungspartikel enthält.

12. Verfahren gemäß Anspruch 11, wobei die Platine eine ebene Platine ist.

13. Verfahren gemäß einem der Ansprüche 11 bis 12, wobei das Harz des äußeren Damms (2) vor dem Härten einen Speichermodul von mehr als 100 Pa aufweist.

14. Verfahren gemäß einem der Ansprüche 11 bis 13, wobei das Harz des äußeren Damms (2) bei Messung mit einer Schergeschwindigkeit von 1 1/s vor dem Härten eine Viskosität von mehr als 100 Pa*s aufweist.

## Revendications

1. Module à diode électroluminescente comprenant une puce à diode électroluminescente (1) montée sur une carte, et une couverture, la couverture comprenant une barrière extérieure (2) appliquée sur la carte, et un remplissage central (3), qui est rempli dans la barrière extérieure (2), la barrière extérieure (2) et le remplissage central (3) étant respectivement réalisés à partir d'une résine de silicone durcie,
dans lequel le remplissage central (3) est lié chimiquement à la barrière extérieure (2) à travers l'interface entre les deux matériaux,
**caractérisé en ce que** la barrière extérieure (2) est non-transparente et comprend des particules réfléchissantes, et le remplissage central (3) comprend des particules de conversion de couleur.

2. Module à diode électroluminescente selon la revendication 1, dans lequel la coupe transversale de la barrière extérieure (2) se rétrécit vers le sommet (10) de la barrière (2) de sorte que la face intérieure (11) de la barrière (2) est inclinée.

3. Module à diode électroluminescente selon la revendication 1 ou 2, dans lequel la surface supérieure du remplissage (3) est au même niveau que la hauteur maximum de la barrière extérieure (2) ou n'est pas complètement de niveau avec le niveau supérieur de celle-ci.

4. Module à diode électroluminescente selon l'une quelconque des revendications précédentes, dans lequel les particules réfléchissantes sont des pigments blancs.

5. Module à diode électroluminescente selon l'une quelconque des revendications précédentes, dans lequel la barrière extérieure (2) comprend de 10 à 60 % en poids de particules réfléchissantes.

6. Module à diode électroluminescente selon l'une quelconque des revendications précédentes, dans lequel la puce à diode électroluminescente (1) est montée sur la carte selon une technologie chip-on-board.

7. Module à diode électroluminescente selon l'une quelconque des revendications précédentes, dans lequel la paroi intérieure de la barrière extérieure (2) est à distance de la puce à diode électroluminescente (1), la distance entre la barrière extérieure (2) et la puce à diode électroluminescente (1) étant remplie avec le remplissage central (3).

8. Module à diode électroluminescente selon l'une quelconque des revendications précédentes, dans lequel le remplissage central (3) remplit le volume entier défini par la barrière extérieure (2).

9. Module à diode électroluminescente selon l'une quelconque des revendications précédentes, dans lequel la barrière extérieure (2) est plus haute que la puce à diode électroluminescente (1).

10. Module à diode électroluminescente selon l'une quelconque des revendications précédentes, dans lequel la hauteur de la barrière extérieure (2) est au moins égale à la hauteur de l'élément destiné à être recouvert.

11. Procédé de fabrication d'un module à diode électroluminescente, le procédé comprenant les étapes suivantes :
- monter une puce à diode électroluminescente (1) sur une carte,
- applique sur la carte une barrière extérieure (2) réalisée à partir d'une résine de silicone liquide non-durcie, la barrière extérieure (2) entourant la puce à diode électroluminescente (1),
- réaliser un remplissage central (3) du volume défini par la barrière extérieure (2), le remplissage central (3) étant réalisé à partir d'une résine de silicone liquide non-durcie recouvrant la surface supérieure de la puce à diode électroluminescente (1),
- durcir en une seule étape la résine de la barrière extérieure (2) et le remplissage central (3) et réaliser une liaison chimique à travers l'interface entre la barrière extérieure (2) et le remplissage central (3),
**caractérisé en ce que**
la barrière extérieure (2) est non-transparente et comprend des particules réfléchissantes, et le remplissage central (3) comprend des particules de conversion de couleur.

12. Procédé selon la revendication 11, dans lequel la carte est une carte plane.

13. Procédé selon l'une quelconque des revendications 11 à 12, dans lequel la résine de la barrière extérieure (2) a un module de conservation supérieur à 100 Pa avant d'être durcie.

14. Procédé selon l'une quelconque des revendications 11 à 13, dans lequel la résine de la barrière extérieure (2) a une viscosité supérieure à 100 Pa*s lors d'une mesure à un taux de cisaillement de 1 1/s avant d'être durcie.
